# EUROPÄISCHE PATENTANMELDUNG

(11) **EP 3 276 682 A1**
(43) Veröffentlichungstag der Anmeldung: **31.01.2018**
(21) Anmeldenummer: 17182778.5
(22) Anmeldetag: 24.07.2017
(51) Int. Cl.: H01L 33/58, F21V 23/06, H01L 25/075, H01L 33/62, F21S 4/28, H01L 25/16

(54) **LEUCHTENBAUGRUPPE MIT SPRITZGEGOSSENEM LED-SCHALTUNGSTRÄGER**

(30) Priorität: 25.07.2016 DE 102016113667
(71) Anmelder: ITZ Innovations- und Technologiezentrum GmbH, 59759 Arnsberg (DE)
(72) Erfinder: Drees, Dipl.-Ing. Frank, 58840 Plettenberg (DE)
(74) Vertreter: Lippert Stachow Patentanwälte Rechtsanwälte

(57) **Zusammenfassung**

Die Erfindung betrifft eine Leuchtenbaugruppe (10), umfassend einen im Wesentlichen ebenen, spritzgegossenen bzw. gepressten Schaltungsträger mit einem zumindest abschnittsweise an den Schaltungsträger gespritzten oder am Schaltungsträger umspritzten bzw. umpressten Steckverbinder; einer auf dem Schaltungsträger aufgebrachten Metallisierung (21) zur Bereitstellung von Leiterbahnen (20, 61) zur Kontaktierung von auf dem Schaltungsträger kontaktierten elektronischen Bauelementen; einer Mehrzahl von auf der Vorderseite (100) des Schaltungsträgers (10) kontaktierten und angeordneten LEDs (30); einer am Schaltungsträger angeordneten Sensoreinrichtung zur Erfassung zumindest einer aus der Gruppe der physikalischen Größen Temperatur, Feuchtigkeit, Luftdruck, Schallfeldgrößen, Lichtgrößen und elektromagnetische Feldgrößen ausgewählten Größe; zumindest einer mit dem Schaltungsträger einstückig hergestellten Befestigungseinrichtung zur lösbaren Befestigung der Leuchtenbaugruppe (10) an einem Leuchtensystem; und ein mit dem Schaltungsträger verbundenes und die LEDs (30) abdeckendes lichtlenkendes optisches System.

## Beschreibung

Die Erfindung betrifft eine Leuchtenbaugruppe mit einem spritzgegossenen Schaltungsträger, die in aktuelle Leuchten einsetzbar sind.

Die Verwendung von organischen oder anorganischen LEDs als Leuchtmittel in Leuchten sowohl für den privaten Bereich als auch im öffentlichen sowie im kommerziellen Bereich hat in den letzten Jahren stark zugenommen. In einer ersten Phase wurden Lampen auf der Grundlage dieser neuen Leuchtmittel und zum Einsatz in bestehende Leuchtengehäuse gestaltet. Zwischenzeitlich werden immer mehr Leuchten von Grund auf neu gestaltet, um die spezifischen Eigenschaften der organischen bzw. anorganischen LEDs besser nutzen zu können, ohne auf in der Regel sub-optimale Gestaltungslösungen, die in der Vergangenheit für die Verwendung von anderen Leuchtmittel entwickelt wurden, zurückgreifen zu müssen.

Eine weitere aktuelle Entwicklung in der Leuchtentechnologie betrifft die Integration von Sensoren und/oder Kommunikationsmittel in die Leuchten zur Erhöhung der Funktionalität. Beispielsweise umfassen solche Leuchten zwischenzeitlich je nach Ausführungsform auch HF-Sensoren oder Antennen, die neben der die LEDs tragenden Schaltungsplatine am Gehäuse der jeweiligen Leuchte befestigt sind.

Derartige Ergänzungen bzw. weitere Bauteile der Leuchte sind dem allgemeinen Streben nach kompakter und kostengünstiger Bauweise einer LED-Leuchte eher abträglich.

Der Erfindung liegt die Aufgabe zugrunde, eine funktionserweiterte Leuchte bereitzustellen, die mit einer kompakten Bauweise und kostengünstig herstellbar ist.

Diese Aufgabe löst die vorliegende Erfindung mit einer Leuchtenbaugruppe, umfassend einen im Wesentlichen ebenen, spritzgegossenen bzw. gepressten Schaltungsträger mit einem zumindest abschnittsweise an den Schaltungsträger gespritzten oder am Schaltungsträger umspritzten bzw. umpressten Steckverbinder, einer auf dem Schaltungsträger aufgebrachten Metallisierung zur Bereitstellung von Leiterbahnen zur Kontaktierung von auf dem Schaltungsträger angeordneten elektronischen Bauelementen, einer Mehrzahl von auf der Vorderseite des Schaltungsträgers kontaktierten und angeordneten LEDs, einer am Schaltungsträger angeordneten Sensoreinrichtung zur Erfassung zumindest einer aus der Gruppe der physikalischen Größen Temperatur, Feuchtigkeit, Luftdruck, Schallfeldgrößen, Lichtgrößen und elektromagnetische Feldgrößen und Erzeugung eines Ausgangssignals, zumindest einer mit dem Schaltungsträger einstückig hergestellten Befestigungseinrichtung zur lösbaren Befestigung der Leuchtenbaugruppe an einem Leuchtensystem und einem mit dem Schaltungsträger verbundenen und die LEDs abdeckenden lichtlenkenden optisches System.

Mit der erfindungsgemäß gestalteten Leuchtenbaugruppe vereinfacht sich der Aufbau und die Gestaltung einer funktional erweiterten Leuchte. Dadurch, dass die Leuchtenbaugruppe auf einem spritzgegossenen bzw. gepressten Schaltungsträger basiert, an bzw. in welchem ein Steckverbinder zumindest abschnittsweise, eine Befestigungseinrichtung zur lösbaren Befestigung der Leuchtenbaugruppe an eine Leuchte oder an einem Leuchtensystem und ferner Sensor-, insbesondere Antennenstrukturen integriert sind, verringert sich das notwendige Bauvolumen sowie die Herstellungskosten, ohne dass sich Gestaltungsmöglichkeiten vermindern. Stattdessen stellt die erfindungsgemäße Leuchtenbaugruppe eine hohe Flexibilität und vielfältige Anpassungsmöglichkeiten zur Abstimmung der Leuchtenbaugruppe an die jeweiligen spezifischen funktionalen Anforderungen bereit.

Die abschnittsweise Integrierung des Steckverbinders im Schaltungsträger kann dabei beispielsweise die Integration eines Abschnittes eines Gehäuses des Steckverbinders im Schaltungsträger, z.B. durch Anspritzung, und/oder die Einbettung von elektrischen Kontakten des Steckverbinders im Schaltungsträger, z.B. durch Umspritzung oder Umpressung, umfassen.

Die mit dem Schaltungsträger einstückig hergestellte Befestigungseinrichtung zur lösbaren Befestigung der Leuchtenbaugruppe an einem Leuchtensystem kann auf vielfältige Art realisiert sein, beispielsweise in Form einer Anlagefläche bzw. eines Anlageflansches, jeweils mit Bohrungen zur Durchführung eines Befestigungsbolzens oder in Form von Rastelementen, die mit komplementär ausgebildeten Rastelementen an einem Träger des Leuchtensystems zur Fixierung der Leuchtenbaugruppe am Leuchtensystem zusammenwirken.

Die Angaben "Schallfeldgrößen, Lichtgrößen und elektromagnetische Feldgrößen" sind jeweils breit zu verstehen und können insbesondere den Schalldruck oder Schallintensität bzw. die Beleuchtungsstärke oder die Lichtwellenlänge bzw. elektromagnetische Feldgrößen zum Bereitstellen einer Antennenfunktionalität meinen.

Vorteilhafte Weiterbildungen der Erfindung sind in der allgemeinen Beschreibung, der Figurenbeschreibung, den Zeichnungen sowie den Unteransprüchen angegeben.

Die Angabe "spritzgegossenen bzw. gepressten Schaltungsträger" kann einen Schaltungsträger umfassend ein duroplastisches und/oder thermoplastisches Material meinen, das mittels eines Spritzgießvorganges und/oder eines Pressvorganges in die gewünschte Gestalt des Schaltungsträgers überführt ist. Die Angabe "Pressen" kann dabei das Umformen eines unausgehärteten Geleges in einer Pressform bzw. "Umpressen" das Einbetten zumindest eines Teils wie eines Leiterstückes durch das besagte "Pressen" bezeichnen.

Insbesondere die Verwendung eines duroplastischen Materials zur Herstellung des Schaltungsträgers bietet den Vorteil, dass die Bildung des Schaltungsträgers bei vergleichsweise niedrigen Temperaturen durchführbar ist, sodass besonders temperaturempfindliche Bauteile wie Sensoren zumindest abschnittweise in den Schaltungsträger einbettbar sind, ohne das die Gefahr einer erhöhten, die Funktionstüchtigkeit des Bauteils beeinträchtigende Temperatur während des Herstellungsprozesses des Schaltungsträgers besteht. Bekannte Herstellungsverfahren wie Duroplast-Spritzgießen, Duroplast-Pressen, Thermoplast-Spritzgießen, jedoch auch Spritzpressen (Transferpressen) und Spritzprägen sind erfindungsgemäß geeignet zur Gestaltung des Schaltungsträgers.

Die erfindungsgemäße Leuchtenbaugruppe ist auf der Grundlage aller bekannten Verfahren zur Herstellung eines spritzgegossenen bzw. gepressten Schaltungsträgers (Molded Interconnect Devices: MID) umsetzbar, bei welchen die spritzgegossenen bzw. gepressten Kunststoffteile mit nach speziellen Verfahren aufgebrachten metallischen Leiterbahnen beaufschlagt werden. Dabei können alle bekannten Verfahren zur Realisierung der Leiterbahnen an bzw. in dem Schaltungsträger verwendet werden. Beispielsweise kann ein Zweikomponenten-Spritzgussverfahren zur Gestaltung des Schaltungsträgers verwendet werden und für das Aufbringen der Leiterbahnen insbesondere ein PCK-Verfahren (PCK: Printed Circuit Board Kollmorgen), bei dem in einem ersten Spritzgießvorgang ein metallisierbarer, nicht elektrisch leitender Kunststoff gespritzt wird, wodurch die jeweilige Leiterbahngeometrie erhaben abgebildet wird und in einem zweiten Spritzgießschritt die Bereiche zwischen den Leiterbahnen mit einem nicht metallisierbaren Kunststoff aufgefüllt werden. Ein weiteres Verfahren für das Aufbringen der Leiterbahnen kann das sogenannte SKW-Verfahren (SKW: Sankyo Kasei Wiring Board) sein, bei dem in einem ersten Spritzgießschritt die Leiterbahnstruktur als Vertiefung mit einer nicht metallisierbaren Komponente gespritzt wird und in einem zweiten Spritzgießschritt diese Bereiche mit der metallisierbaren Komponente aufgefüllt werden. Nachfolgend kann zunächst die Oberfläche des metallisierbaren Kunststoffs aktiviert und danach die entsprechenden Metalle auf den metallisierbaren Kunststoff aufgebracht werden. Ein anderes Verfahren zum Aufbringen von Leiterbahnen an einen spritzgegossenen Schaltungsträger betrifft das MID-Heißprägen, bei dem zunächst der die geometrische Endform darstellende Schaltungsträger als Spritzgussteil hergestellt wird und eine entsprechend der gewünschten Metallisierung oberflächenmodifizierte Metallfolie mit einem Prägewerkzeug gestanzt und gleichzeitig durch Aufwendung von Druck und Wärme mit dem Spritzgussteil verbunden wird, wobei die Metallfolie für den Verbindungsprozess mit einer Klebstoffschicht versehen wird. Bei einem anderen Herstellungsprozess für einen spritzgegossenen Schaltungsträger mit metallischen Leiterbahnen kann das sogenannte LDS (Laser-Direkt-Strukturierung)-Verfahren verwendet werden, bei dem ein thermoplastischer Kunststoff, der mit einer nichtleitenden und Laser-aktivierbaren Metallverbindung dotiert ist, genutzt wird, um den spritzgegossenen Schaltungsträger herzustellen. Ein Laserstrahl schreibt danach die Leiterbahnen auf das Spritzgussteil, wobei an den entsprechenden Stellen Metallteile abgespalten werden, welche als Keime für eine nachfolgende Metallisierung in einem stromlosen Kupferbad dienen. Darüber hinaus ist auch die sogenannte subtraktive Laserstrukturierung bekannt, bei der die gesamte Bauteiloberfläche des spritzgegossenen Schaltungsträgers metallisiert und nachfolgend mit einem Ätzresist beaufschlagt wird, wobei mittels eines Lasers der Ätzresist strukturiert und nachfolgend die freigelegte Metallschicht weggeätzt wird. Ein weiteres mögliches Verfahren zur Metallisierung des Schaltungsträgers ist das Plasmaspritzen, bei welchem im Plasmastrahl aufgeschmolzenes Kupfer auf den Schaltungsträger aufgetragen wird, wobei die Strukturierung beispielsweise mittels einer Maskierung oder durch Auftragen eines Antihaftungslacks realisiert sein kann.

Es sei bemerkt, dass die angegebenen verschiedenen Herstellungsverfahren nur einen Teil der möglichen Verfahren darstellen, die zur Herstellung der erfindungsgemäß ausgebildeten Leuchtenbaugruppe verwendet werden können. Wie erläutert, können sowohl thermoplastische als auch duroplastische Kunststoffe als Basis zur Herstellung des spritzgegossenen bzw. gepressten Schaltungsträgers zum Einsatz kommen. Da derartige Verfahren zur Herstellung eines spritzgegossenen bzw. gepressten Schaltungsträgers mit metallischen Leiterbahnen dem Fachmann wohl bekannt sind, muss darauf nicht weiter eingegangen werden.

Zweckmäßigerweise kann eine auf dem Schaltungsträger aufgebrachte Metallisierung und/oder zumindest ein umspritztes metallisches Leiterelement zur Bereitstellung von Leiterabschnitten einer als elektronmagnetisch wirksame Antennenstruktur ausgebildete Sensoreinrichtung vorgesehen sein.

Zur weiteren Erhöhung des Integrationsgrades kann zweckmäßigerweise vorgesehen sein, dass Leiterbahnabschnitte, insbesondere zur Antennenstruktur gehörige Leiterbahnabschnitte am spritzgegossenen bzw. gepressten Schaltungsträger der erfindungsgemäßen Leuchtenbaugruppe vollständig im Schaltungsträger umspritzt bzw. umpresst sind. Beispielsweise kann vorgesehen sein, dass diese "vergrabenen" Leiterbahnabschnitte Stanzteile sind, welche bei der Herstellung des spritzgegossenen Schaltungsträgers umspritzt bzw. umpresst werden können.

Je nach Ausführungsform kann zumindest die Sensoreinrichtung wie ein Thermosensor oder ein Lichtsensor zumindest abschnittsweise im Schaltungsträger umspritzt bzw. umpresst sein. Beispielsweise kann ein Sensor wie ein Thermosensor in Form eines PT100-Sensors vollständig im Volumenmaterial des Schaltungsträgers eingebettet sein, sodass dieser eine genaue Messung der Schaltungsträgertemperatur ermöglichen kann bzw. besonders gegen Umgebungseinflüsse geschützt ist. In ähnlicher Weise kann beispielsweise ein Sensor wie ein Lichtsensor abschnittsweise in den Schaltungsträger eingebettet sein, insbesondere so, dass allein die Sensorfläche zum Empfang des Lichtes freiliegt, wodurch beispielsweise Abschattungen, die durch den Sensor selbst verursacht sind, vermieden werden können oder der Sensor gegen äußere Einflüsse geschützt ist.

Aufgrund der beschriebenen hohen Flexibilität bezüglich der Anpassung des spritzgegossenen bzw. gepressten Schaltungsträgers an die gewünschte Funktionalität, beispielsweise zur Realisierung einer Kommunikation über eine Luftschnittstelle mit Antennenstruktur bzw. zur Realisierung eines anderen Sensors, können hierzu genutzte metallisierte Bereiche auf bzw. in den Schaltungsträger auf vielfältige Weise ausgeführt sein. Beispielsweise kann vorgesehen sein, dass eine als Antenne genutzte Leiterbahn eine Mehrzahl von Teilbereichen umfasst, die jeweils separat über eigene Kontakte verbunden sein können. Darüber hinaus kann vorgesehen sein, dass die als Antenne genutzten Teilbereiche der Leiterbahn bzw. Leiterbahnabschnitte jeweils separat durch das Vorsehen entsprechender Bauelemente aktiv geschaltet bzw. getrennt voneinander ausgewertet werden. Darüber hinaus ist liegt es im Rahmen der Erfindung als Antenne genutzten Leiterbahnabschnitte über eine Steckverbindung, die vorzugsweise zumindest abschnittsweise im spritzgegossenen Schaltungsträger integriert sein kann, mit einer Auswerteelektronik zu verbinden. Zur Optimierung des Empfangs- und/oder Abstrahlverhalten der jeweiligen, durch die auf bzw. im Schaltungsträger angebrachten Leiterbahnabschnitte realisierte Antenne kann vorgesehen sein, dass auf dem Schaltungsträger verlaufende und/oder in diesem umspritzte bzw. umpresste Leiterbahnabschnitte abgeschirmt sind.

Vorzugsweise kann vorgesehen sein, dass zur Optimierung der Empfangs-/Sendeeigenschaften des Sensors bzw. der Antenne der ebene, spritzgegossene bzw. gepresste Schaltungsträger zumindest eine aus seiner Hauptebene herausragende geometrische Strukturierung aufweist, auf welcher die jeweilige Metallisierung, beispielsweise zur Realisierung einer vorgegebenen Antennenstruktur mit vorgegebenen Empfangs-/Sendeeigenschaften gestaltet ist. Eine derartige geometrische Strukturierung kann jedoch auch zur Bereitstellung anderer Funktionalitäten umgesetzt sein, beispielsweise zur Bereitstellung einer Befestigungseinrichtung zur lösbaren Befestigung der Leuchtenbaugruppe an einem Leuchtengehäuse oder einem Leuchtensystem, zur Bereitstellung einer Befestigungseinrichtung zur Befestigung des die LEDs abdeckenden, lichtlenkenden optischen Systems an dem Schaltungsträger, zur Bereitstellung einer Steckerfunktionalität an dem Schaltungsträger und/oder zur Bereitstellung einer schalenartigen Struktur, die sich von dem im Wesentlichen ebenen Teil des Schaltungsträgers weg erstreckt, wobei die Innenmantelfläche der schalenartigen Struktur metallisiert sein kann. Eine derartige Strukturierung kann insbesondere zur Bereitstellung einer Abschirmung vorgesehen sein, um beispielsweise ein richtungsabhängiges Sende-/Empfangsverhalten der Antenne bzw. des Sensors bereitzustellen, oder beispielsweise zur Abschirmung von elektronischen Bauelementen, die innerhalb der schalenartigen Struktur angeordnet sein können.

Die beschriebene, aus der Hauptebene des Schaltungsträgers herausragende geometrische Strukturierung kann an die jeweilige Anwendung angepasst sein und beispielsweise insbesondere zur Realisierung einer Antennen- oder Sensorfunktionalität die Gestalt einer Halbkugel, eines Prismas, eines Quaders oder auch eines Pyramidenstumpfes umfassen.

Zur Vermeidung von Abschattungen und zur Minimierung des Platzbedarfes für die erfindungsgemäße Leuchtenbaugruppe kann zweckmäßigerweise vorgesehen sein, dass der Schaltungsträger von der Vorderseite, d.h. der Seite des Schaltungsträgers, an welcher die LEDs angeordnet sind, eine Durchkontaktierung auf die Rückseite, d.h. auf die gegenüberliegende Seite aufweist zum Anschließen an eine einseitig angeordnete Schaltungs- oder Anschlussanordnung. Diese Durchkontaktierung kann insbesondere über Stanzteile erfolgen, welche beim Herstellungsvorgang des Schaltungsträgers umspritzt bzw. umpresst werden und die sowohl an der Vorderseite als auch an der Rückseite des Schaltungsträgers an dort metallisierte Leiterbahnen und/oder Metallisierungsabschnitte kontaktiert oder als Kontakte eines mitgespritzten Steckers vorgesehen sind.

Erfindungsgemäß kann die am Schaltungsträger angeordnete Befestigungseinrichtung zur lösbaren Befestigung der Leuchtenbaugruppe an einem Leuchtengehäuse oder einem Leuchtensystem beispielsweise zumindest ein Rastelement zum Zusammenwirken mit einem komplementären Rastelement am Leuchtengehäuse oder an einem Leuchtensystem umfassen oder zumindest eine Ausnehmung oder Durchgangsbohrung zur Verschraubung.

In einer weiteren Ausführungsform kann das Bereitstellen eines Anlageflansches vorgesehen sein, an welchem der Schaltungsträger an einem Leuchtengehäuse oder einem Leuchtensystem anliegt und befestigt ist.

Wie bereits erläutert, kann der ebene, spritzgegossene Schaltungsträger sowohl auf der Vorderseite als auch auf seiner Rückseite metallisiert sein zur Gestaltung von Leiterbahnen bzw. Leiterbahnabschnitte, wobei elektronische Bauteile auf der Rückseite des Schaltungsträgers angeordnet sein können, welche beispielsweise zur Speisung oder Ansteuerung der an der Vorderseite des Schaltungsträgers angeordneten LEDs mittels Durchkontaktierungen mit diesen verbunden sind.

Je nach spezifischer Ausführungsform kann zweckmäßigerweise auch vorgesehen sein, Metallisierungen wie Leiterbahnen bzw. Leiterbahnabschnitte auf zumindest einer der Stirnseiten des Schaltungsträgers aufzubringen. Eine solche Stirnseite bzw. ein solcher Randbereich des spritzgegossenen Schaltungsträgers kann in Bezug auf seine Geometrie, d.h. den Verlauf zu der Hauptebene angepasst gestaltet sein, beispielsweise als ebene Fläche mit einem Winkel von etwa 230° bis 90° zu der Hauptebenen. Es liegt im Rahmen der Erfindung, diesen Randbereich nicht eben, sondern in besonderen Ausführungsformen zumindest abschnittsweise gekrümmt zu gestalten. Hierdurch können beispielsweise zu einer Antennen- bzw. Sensorstrukturierung gehörende Metallisierungen an spezifische Empfangs- bzw. Sendeeigenschaften angepasst werden.

Vorzugsweise kann vorgesehen sein, Antennen- und/oder Sensorstrukturen, welche sich aus mehreren Teilabschnitten von Metallisierungen bzw. Leiterbahnen zusammensetzen, durch das Vorsehen einer Vielzahl von Kontakten zur getrennten Kontaktierung der einzelnen Teilbereiche der Antennen- und/oder Sensorstrukturen separat zueinander auszuwerten bzw. aktiv zu schalten. Insofern können beispielsweise an der Rückseite des gegossenen Schaltungsträgers angeordnete Bauelemente jeweils spezifisch mit den verschiedenen Teilbereichen der Antennenstrukturierung verbunden und diesen beispielsweise zur Auswertung und/oder zur Aktivschaltung zugeordnet sein.

In einer besonders zweckmäßigen Ausführungsform der erfindungsgemäßen Leuchtenbaugruppe kann vorgesehen sein, dass die zumindest eine aus der Hauptebene des Schaltungsträgers herausragende geometrische Strukturierung eine schalenartige Struktur, insbesondere in Form von Wandungen umfasst, die sich von dem im Wesentlichen ebenen Teil des Schaltungsträgers weg erstreckt. Dabei kann vorgesehen sein, dass die Innenmantelfläche der schalenartigen Struktur, insbesondere Seitenabschnitte an ihrer Innenseite metallisiert sein. In dieser Ausführungsform kann der schalenartig aufgebaute Schaltungsträger für innenseitig angeordnete elektronische Bauteile durch Seitenwandabschnitte einen geschützten Volumenbereich bereitstellen, der durch Metallisierungen an den Innenseitenflächen auch abgeschirmt sein kann. Anschlüsse zwischen den geschützt angeordneten elektronischen Bauelementen zu den an der Außenseite in der Hauptebene des Schaltungsträger angeordneten LEDs kann dabei vorzugsweise über Durchkontaktierungen realisiert sein, die beispielsweise über umspritzte bzw. umpresste Stanzteile bereitgestellt werden können, die sich zwischen der Vorderseite und der Rückseite des Schaltungsträgers erstrecken können.

In einer besonderen Ausführungsform kann auch vorgesehen sein, die Antennenstruktur als vollständig im Kunststoff des Schaltungsträgers eingebettetes Leiterelement, insbesondere in Form eines Stanzgitters auszuführen. Dabei kann das Leiterelement zur Gestaltung spezifischer Empfangs-/Sendeeigenschaften abschnittsweise abgeschirmt sein durch die Anordnung einer metallischen, geschlossenen oder gitterartigen Ummantelung, die das Leiterelement bzw. das Stanzgitter umgibt und beabstandet zu diesem angeordnet ist.

In einer zweckmäßigen Ausführungsform kann vorgesehen sein, dass der zumindest abschnittsweise gespritzte oder umspritzte bzw. umpresste Steckverbinder zur Kontaktierung der Leuchtenbaugruppe mit einer elektrischen Versorgung und/oder zur Kontaktierung der Antennenstruktur mit einer elektronischen Auswerteschaltung zur Auswertung der empfangenen elektromagnetischen Strahlung ausgebildet ist. Beispielsweise kann vorgesehen sein, dass Durchkontaktierungen des Schaltungsträgers von der Vorderseite auf die Rückseite zu an der Rückseite gespritzte oder umspritzte bzw. umpresste Steckverbinder geführt sind, über welche eine Verbindung mit einer separaten Schaltungsplatine erfolgt, die an der Rückseite des Schaltungsträgers angeordnet sein kann und elektronische Bauelemente trägt, beispielsweise zur Auswertung der von der Antennenstruktur erfassten Signale.

Insbesondere bei solchen Ausführungsformen, bei welchen elektronische Bauelemente an der Rückseite des spritzgegossenen Schaltungsträgers angeordnet sind und der Schaltungsträger schalenartig aufgebaut ist, kann vorgesehen sein, dass dieser rückseitig eine auf den Schaltungsträger aufsetzbare bzw. mit diesem verbindbare Abdeckung aufweist zum Schutz dieser elektronischen Komponenten.

Es liegt im Rahmen der Erfindung, die beschriebenen Metallisierungen auf dem Schaltungsträger sowohl zur Kontaktierung von Bauelementen als auch zumindest abschnittsweise zur Bereitstellung der elektromagnetisch wirksamen Antennenstrukturierung zu verschalten. Insofern kann ein auf dem Schaltungsträger angeordneter Leiterbahnabschnitt durch das Vorsehen entsprechender elektronischer Filter mehrfunktional eingesetzt sein.

Vorzugsweise kann das mit dem Schaltungsträger verbundene und die LEDs abdeckende, optische System als transparente, transluzente Abdeckung ausgebildet sein, welches neben einer lichtlenkenden und/oder lichtstreuenden Funktion darüber hinaus einen Schutz der LEDs beziehungsweise der Schaltung gegen Feuchtigkeit und Schmutz darstellen kann. Hierzu kann vorgesehen sein, die Abdeckung mit dem Schaltungsträger zu verrasten. In einer weiteren Ausführungsform kann die Abdeckung auch mit dem Schaltungsträger verklebt sein.

Bei solchen Ausführungsformen, bei welchen der Schaltungsträger eine aus der Hauptebene herausragende geometrische Strukturierung aufweist, kann zweckmäßigerweise vorgesehen sein, dass die transparente, transluzente Abdeckung daran angepasst ist zur Bereitstellung eines Freiraums für die 3D-Strukturierung.

Die Erfindung wird im Folgenden durch das Beschreiben einiger Ausführungsformen unter Bezugnahme auf die Figuren erläutert, wobei
- Figur 1: eine perspektivische Ansicht auf einen ebenen, spritzgegossenen Schaltungsträger einer ersten Ausführungsform einer erfindungsgemäßen Leuchtenbaugruppe,
- Figur 2: den Schaltungsträger gemäß Figur 1 mit einer aufgesetzten transluzenten Abdeckung,
- Figur 3: die Leuchtenbaugruppe gemäß Figur 2 in einer perspektivischen Unteransicht,
- Figur 4: eine weitere Ausführungsform eines ebenen, spritzgegossenen Schaltungsträgers zur Gestaltung einer erfindungsgemäßen Leuchtenbaugruppe in einer perspektivischen Aufsicht,
- Figur 5: eine perspektivische Teilschnittdarstellung eines ebenen, spritzgegossenen Schaltungsträgers einer dritten Ausführungsform,
- Figur 6: einen ebenen, spritzgegossenen Schaltungsträger einer vierten Ausführungsform in einer perspektivischen Aufsicht,
- Figur 7: eine perspektivische Unteransicht auf den spritzgegossenen Schaltungsträger gemäß Figur 6,
- Figur 8: den Schaltungsträger gemäß Figur 7 in einem Längsschnitt mit aufgesetzter Elektronikabdeckung,
- Figur 9: eine fünfte Ausführungsform eines ebenen, spritzgegossenen Schaltungsträgers in einer perspektivischen Ansicht zur Gestaltung einer erfindungsgemäßen Leuchtenbaugruppe,
- Figur 10: ein Detailschnitt in Längsrichtung des in Figur 9 gezeigten Schaltungsträgers und
- Figur 11: in einer frontalen Aufsicht die Antennenstruktur des Schaltungsträgers gemäß Figur 9 im Detail
zeigt.

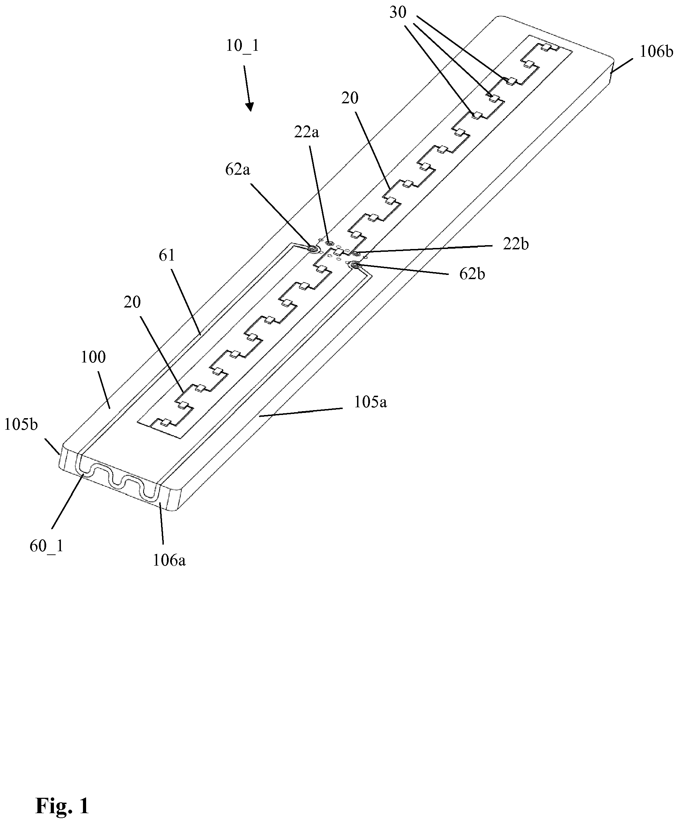

Figur 1 zeigt eine erste Ausführungsform eines ebenen, aus einem Thermoplast- oder Duroplastmaterial spritzgegossenen Schaltungsträgers 10_1 in einer perspektivischen Aufsicht. Das Spritzgussteil weist auf seiner Oberseite 100 über Leiterbahnen 20 seriell kontaktierte LEDs 30 auf, die äquidistant beabstandet mittig auf dem langgestreckten, etwa rechteckförmig gestalteten Schaltungsträger platziert sind. Ausgehend von der Hauptebene des Schaltungsträgers erstrecken sich etwa senkrecht zur Hauptebene längs verlaufende Seitenwandungen 105a, 105b sowie quer verlaufende Seitenwandungen 106a, 106b, sodass der Schaltungsträger eine schalenartige Gestaltung aufweist. Neben den Leiterbahnen 20 zur seriellen Verschaltung der LEDs 30 weist der in Figur 1 angegebene Schaltungsträger 10_1 an der quer verlaufenden Seitenwandung 106a eine Antennenstrukturierung 60_1 auf, welche an dieser Stelle etwa senkrecht zu den Leiterbahnen 20 zwischen den LEDs orientiert ist. Diese Antennenstrukturierung dient in der beschriebenen Ausführungsform zum Senden und Empfangen von elektromagnetischen Wellen, beispielsweise zur Kommunikation zwischen einer zentralen Steuereinheit und einer Leuchtensteuerung, die an die Antennenstruktur 60_1 in noch zu beschreibender Art und Weise angeschlossen ist. Leiterbahnen 61 der Antennenstruktur als auch Leiterbahnen 20 der LED-Versorgung sind in der beschriebenen Ausführungsform an einen zentralen Kontaktbereich am Schaltungsträger 10_1 geführt, der hier an der Oberseite 100 etwa in der Mitte des Schaltungsträgers vorgesehen ist. Erkennbar sind Antennenanschlüsse 62a, b sowie Versorgungsanschlüsse 22a, b zur Speisung der LEDs 30.

Die Metallisierung des Schaltungsträgers 10_1, d.h. die Gestaltung der beschriebenen Leiterbahnen 20, 61 auf dem spritzgegossenen Schaltungsträger sind auf herkömmliche Art ausgeführt, sodass darauf nicht näher eingegangen werden muss.

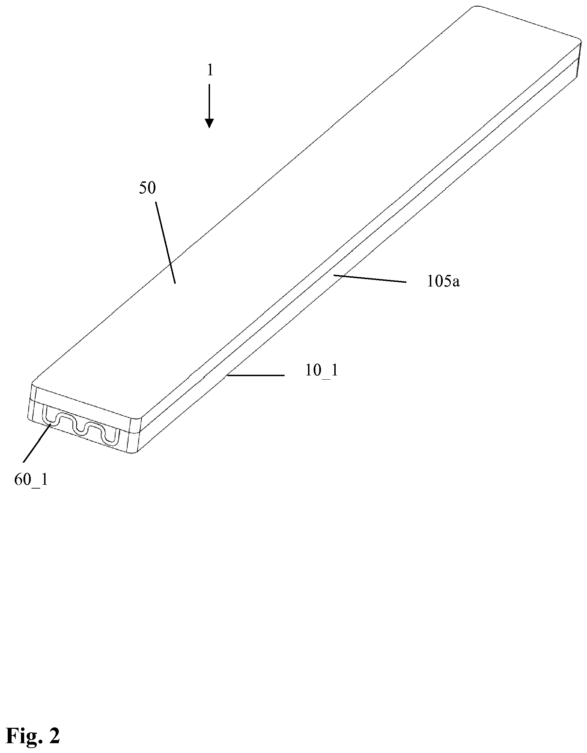

Figur 2 zeigt die fertiggestellte Leuchtenbaugruppe 1 durch Aufsetzen und Verkleben einer transluzenten Abdeckung 50 auf die Oberseite des Schaltungsträgers 10_1, siehe Figur 1. Die Abdeckung 50 ist hier schalenartig ausgebildet und liegt umfänglich geschlossen auf entsprechenden Anlageflächen an der Oberseite des Schaltungsträgers 10_1 auf, sodass zwischen beiden Teilen ein geschlossener Hohlraum gebildet ist, in welchem die LED-Anordnung aufgenommen und geschützt ist.

Die Abdeckung 50 ist in der beschriebenen Ausführungsform mit ebenen Wandungen ausgebildet, wobei das von den LEDs 30 emittierte Licht im Volumen der Abdeckung so gestreut wird, dass für einen Betrachter eine Auflösung der einzelnen LEDs nicht mehr möglich ist und somit der Eindruck einer homogenen, lichtabgebenden Linie entsteht. Zur gezielten Lichtlenkung kann die Abdeckung 50 strukturiert sein, beispielsweise um vorgegebene Lichtverteilungskurven bereitzustellen.

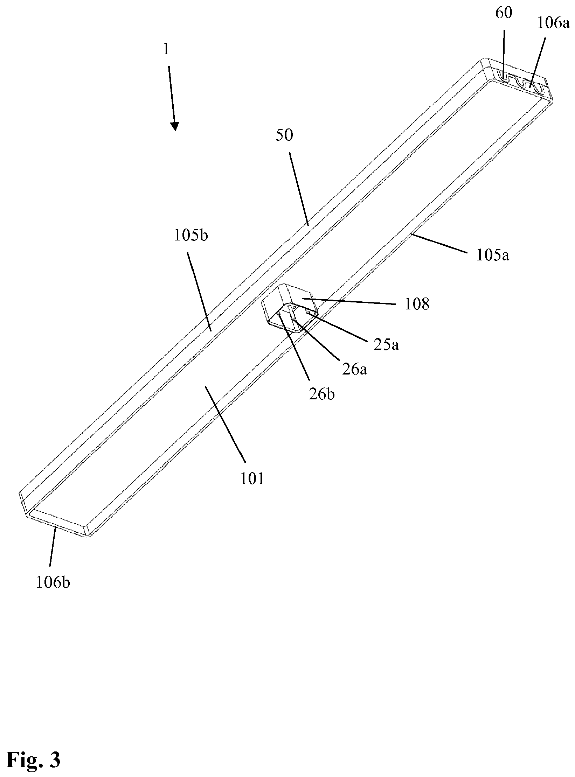

Figur 3 zeigt die Leuchtenbaugruppe gemäß Figur 2 in einer perspektivischen Unteransicht. Erkennbar ist die schalenartige Struktur des Schaltungsträgers, bei dem sich die längs verlaufenden Seitenwandungen 105a, b und die quer verlaufenden Seitenwandungen 106a, b senkrecht von der Unterseite 101 erstrecken. Erkennbar ist ferner ein integral mit dem Schaltungsträger hergestelltes Steckergehäuse 108, das etwa senkrecht zur Hauptebene des Schaltungsträgers verlaufende Kontaktstifte 26a, b, 25a beinhaltet und schützt. Diese Kontaktstifte verlaufen von der Oberseite 100 über die Unterseite 101 des Schaltungsträgers hinaus und stellen beim Herstellungsvorgang des Schaltungsträgers umspritzte Metallteile dar, welche bei der nachfolgenden Metallisierung des Schaltungsträgers eine Kontaktierung von der Oberseite 100 zur Rückseite 101 des Schaltungsträgers bereitstellen. In der beschriebenen Ausführungsform sind die Antennenanschlüsse 62a, b mit den zugeordneten Kontaktstiften 26a, b verbunden. In gleicher Weise ist der in Figur 3 sichtbare Kontaktstift 25a mit einem der beiden Anschlüsse 42a, b verbunden, siehe Figur 1. Die Kontaktierung der beiden Enden der LED-Reihenschaltung erfolgt in der beschriebenen Ausführungsform durch zwei sich parallel zur Hauptebene des Schaltungsträgers in diesem erstreckenden Metallstanzteile, die insofern zusammen mit den Kontaktstiften 25a, b, 26a, b bei der Herstellung des Schaltungsträgers umspritzt werden.

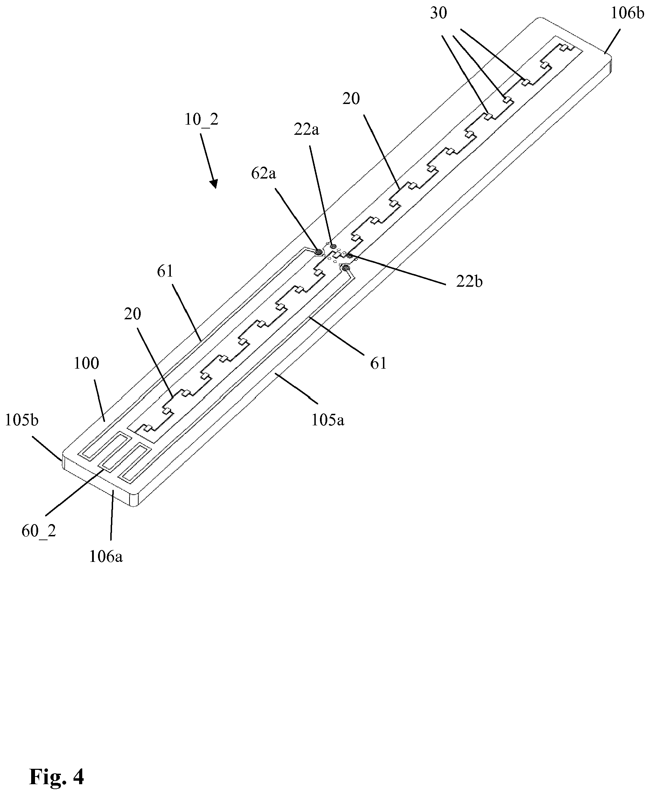

Figur 4 zeigt eine weitere Ausführungsform eines Schaltungsträgers 10_2, der mit Ausnahme der Antennenstruktur 60_2 identisch zu dem Schaltungsträgers gemäß Figur 1 aufgebaut ist. Erkennbar ist die Antennenstruktur 60_2 an der Oberseite 100 des Schaltungsträgers 10_2 aufmetallisiert.

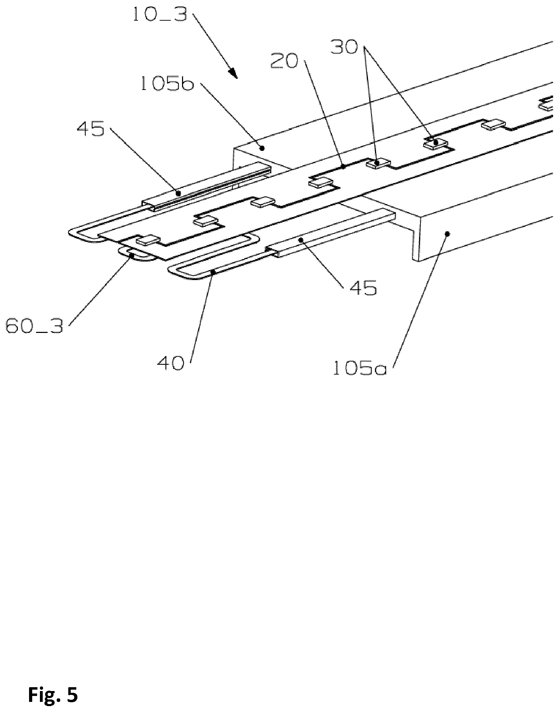

Figur 5 zeigt im Ausschnitt in einer perspektivischen Ansicht und in einem Teilschnitt senkrecht zur Längsachse eine weitere Ausführungsform eines Schaltungsträgers 10_3 zur Gestaltung einer erfindungsgemäß aufgebauten Leuchtenbaugruppe. Der Schaltungsträger 10_3 ist bis auf die Gestaltung der Antennenstruktur 60_1, 60_2 identisch mit den in Bezug auf die Figuren 1 und 4 angegebenen Schaltungsträgern. Die Antennenstruktur 60 3 des Schaltungsträgers der Figur 5 wird durch ein Metallelement in Form eines Stanzgitters 40 gebildet, das beim Spritzgießvorgang zur Herstellung des Schaltungsträgers umspritzt wird, sodass das Stanzgitter im Volumen des Schaltungsträgers 10_3 vollständig eingebettet ist. Erkennbar verläuft die Antennenstruktur 60 3 abschnittsweise unterhalb der LED-Reihenanordnung. Zur Festlegung der Empfangseigenschaften der Antennenstruktur 60_3 sind in der beschriebenen Ausführungsform Leiterabschnitte 45 vorgesehen, die hier Zuleitungsabschnitte der Antennenstruktur 60_3 beabstandet umgeben und elektromagnetisch abschirmen, sodass die entsprechenden Abschnitte allein zur Verbindung der Antenne an die hier auch mittig auf dem Schaltungsträger platzierten Kontaktabschnitte dienen.

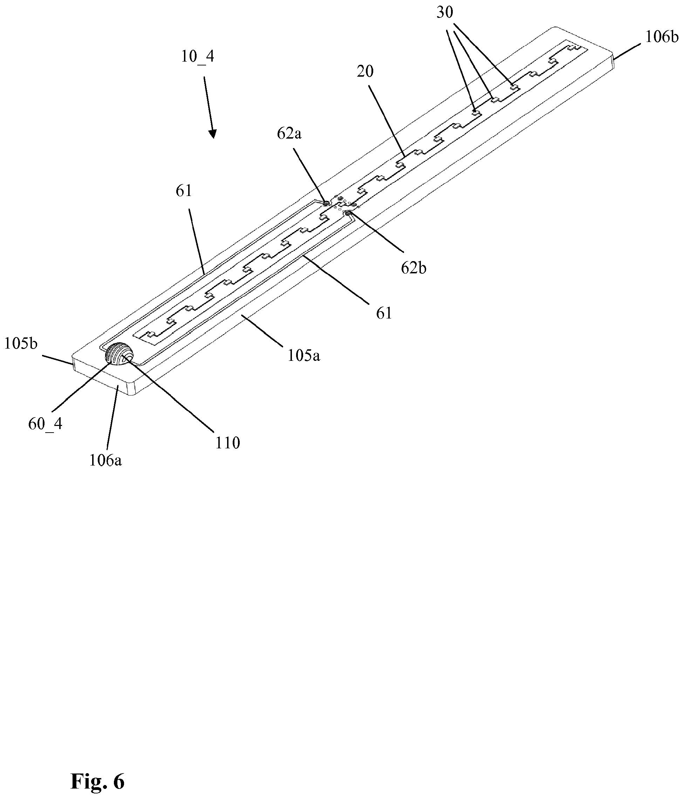

Figur 6 zeigt eine weitere Ausführungsform eines Schaltungsträgers 10_1 zur Gestaltung einer erfindungsgemäßen Leuchtenbaugruppe in einer perspektivischen Aufsicht. Der Schaltungsträger ist bis auf die Antennenstruktur 60_4 identisch zu dem Schaltungsträger gemäß Figur 1 aufgebaut. Insofern weist es eine schalenförmige Gestalt auf, bei welcher sich geschlossene Seitenwandabschnitte 105a, b und 106a, b etwa senkrecht von der Hauptebene des Schaltungsträgers 10_4 von der Unterseite erstrecken. Die Antennenstruktur 60_4 umfasst eine etwa halbkugelförmige Gestalt, die integral mit dem Schaltungsträger durch Spritzgießen erzeugt ist, wobei die Oberfläche der sich aus der Hauptebene erstreckende Halbkugel 110 zur Bereitstellung vorgegebener Empfangseigenschaften mit metallisierten Leiterbahnen versehen ist. Die Kontaktierung erfolgt wiederum über die Leiterbahn 61 an die Antennenanschlüsse 62a, b.

In nicht dargestellten Ausführungsformen kann die 3D-Strukturierung der Antenne auch andere Gestaltformen in Abhängigkeit der vorgegebenen Empfangseigenschaften der Antennenstruktur aufweisen, beispielsweise als Pyramidenstumpf oder Prisma ausgebildet sein. Darüber hinaus liegt es im Rahmen der Erfindung, auch mehrere derartige Antennenstrukturierungen vorzusehen, die jeweils auf einer spezifisch und sich von der Hauptebene des Schaltungsträgers erstreckenden 3D-Aufbaus angeordnet sein können. Hierzu kann die Oberfläche der 3D-Gestaltung wiederum in angepasster Weise metallisiert sein.

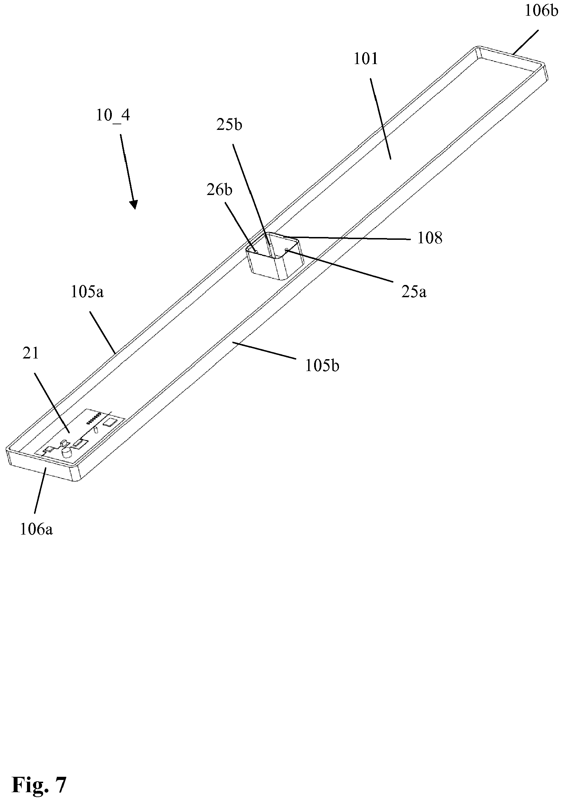

Figur 7 zeigt den Schaltungsträger 10_1 der Figur 6 in einer perspektivischen Unteransicht mit dem integral hergestellten Steckergehäuse 108, das in Bezug auf den gesamten Aufbau identisch mit dem des Steckergehäuses des Schaltungsträgers 10_1 der Figur 3 ist. In der beschriebenen Ausführungsform weist die Unterseite 101 des Schaltungsträgers 10_1 an einem Längsende eine Metallisierung 21 auf zur Kontaktierung von dort angebrachten elektronischen Bauteilen, beispielsweise zur Bereitstellung einer Auswerteschaltung für die Antennenstruktur 60_4. Die Kontaktierung der Auswerteschaltung mit den entsprechenden Kontaktstiften im Steckergehäuse 108 kann in nicht dargestellter Weise über eine Kabelverbindung erfolgen.

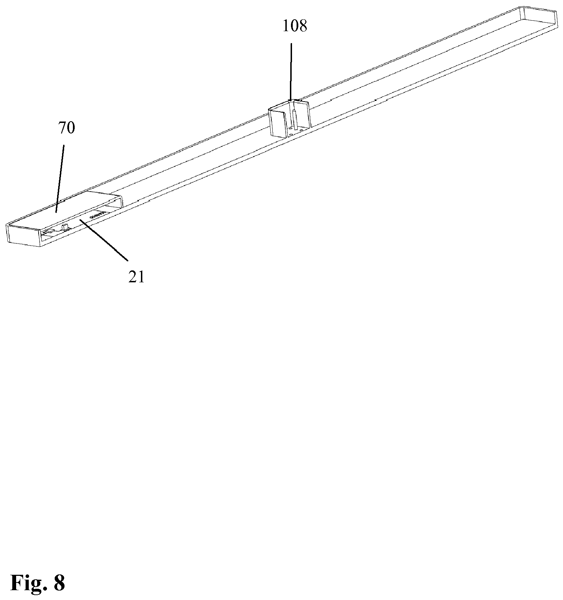

In einer nicht dargestellten Ausführungsform kann auch vorgesehen sein, dass die jeweilige Antennenstruktur über Kontaktstifte, die sich zur Herstellung einer elektrischen Verbindung zwischen Metallisierungsstrukturen an der Oberseite 100 und der Unterseite 101 des Schaltungsträgers durch diesen hindurch erstrecken, direkt mit einer an der Unterseite angeordneten Schaltungsanordnung, wie sie beispielhaft in Figur 7 angegeben ist, verbunden ist. Insofern kann die Leiterbahn 61 entfallen, siehe Figur 4, welche die jeweilige Antennenstruktur mit den mittig zum Schaltungsträger angeordneten Kontaktstiften verbindet. Zum Schutz der an der Unterseite 101 des Schaltungsträgers angeordneten elektronischen Schaltung kann eine Elektronikabdeckung 70 vorgesehen sein, wie sie in Figur 8 im Rahmen einer Längsschnittdarstellung angegeben ist.

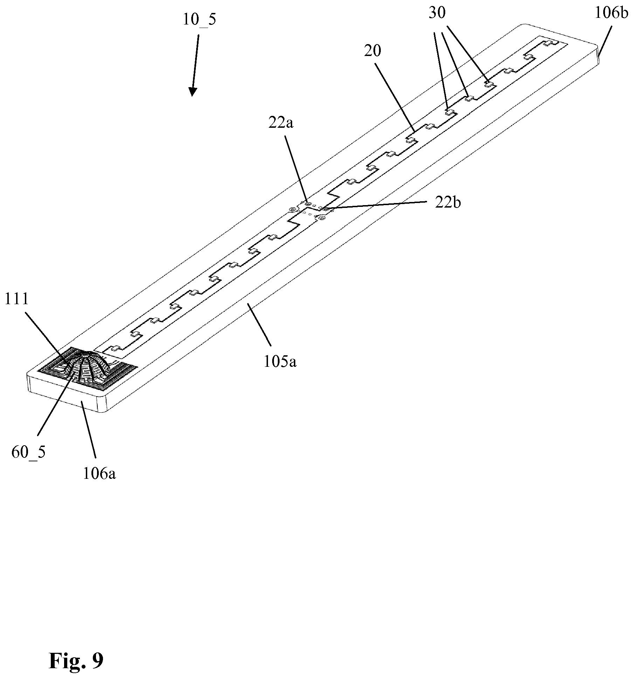

Figur 9 zeigt eine weitere Ausführungsform eines Schaltungsträgers 10_5 zur Gestaltung einer erfindungsgemäßen Leuchtenbaugruppe, wobei dieser Schaltungsträger wiederum bis auf die Antennenstruktur 60_5 und deren Kontaktierung identisch zu dem Schaltungsträger 10_1 der Figur 1 aufgebaut ist. Die Metallisierung der Antennenstruktur ist wie in der Ausführungsform gemäß Figur 6 auf einer sich von der Hauptebene des Schaltungsträgers an dessen Vorderseite 100 sich erstreckende Halbkugel 111 gestaltet. Im Unterschied zu der Variante gemäß Figur 6 weist die Antennenstruktur 60_5 eine Vielzahl von umfänglich beabstandeten Antennensegmenten auf, die unabhängig voneinander kontaktierbar sind.

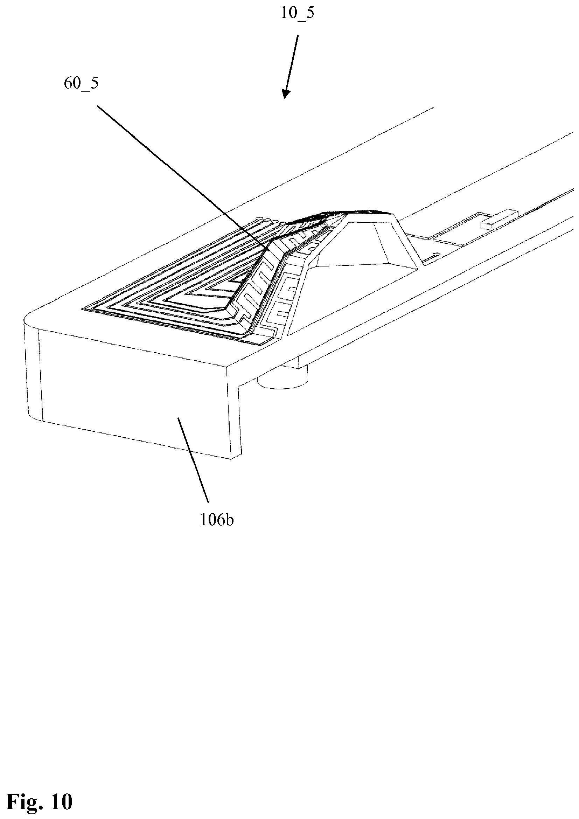

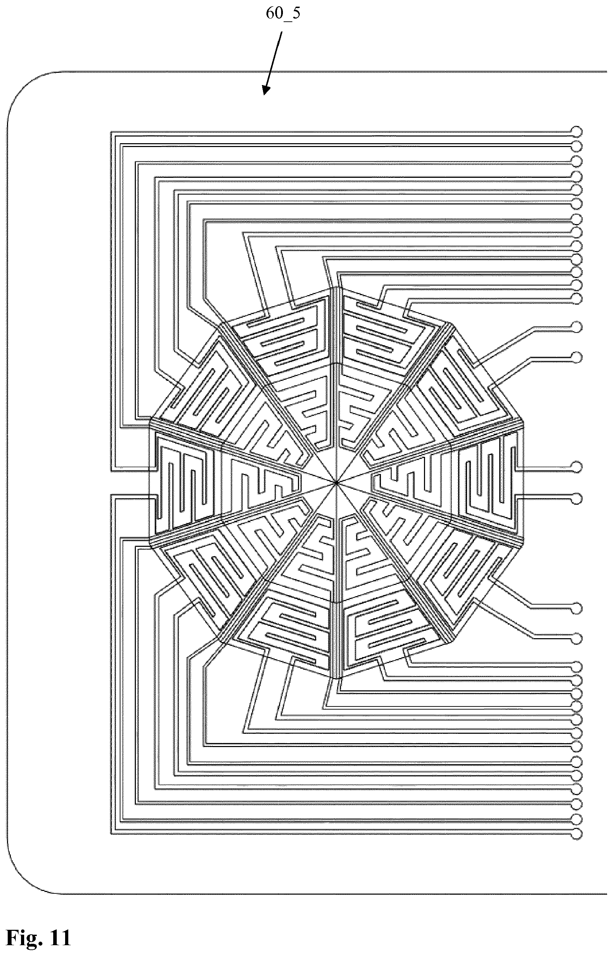

Figur 10 zeigt Details zur Antennenstruktur 60 5 in einer Schnittdarstellung längs zum Schaltungsträger, Figur 11 zeigt die Metallisierung der Halbkugel 111 in einer frontalen Aufsicht im Detail. Eine Kontaktierung der Antennenstruktur 60_5 zu einer an der Unterseite des Schaltungsträgers angeordneten Auswerteschaltung kann beispielsweise wiederum über entsprechende Kontaktstifte realisiert sein, die sich durch den Schaltungsträger hindurch erstrecken und bei der Herstellung des Schaltungsträgers mit Kunststoff umspritzt werden, siehe Figur 11.

In einer weiteren Ausführungsform der Erfindung ist der Schaltungsträger der Leuchtenbaugruppe nicht mittels eines Spritzgießvorganges hergestellt, sondern mittels eines Pressvorganges mit einem Duroplastmaterial, wobei wiederum Leiterabschnitte und/oder Bauteile wie Sensoren oder Antennenstrukturen zumindest abschnittsweise durch Umpressen der Teile mit dem Duroplastmaterial zumindest abschnittsweise im Schaltungsträger eingebettet sein können.

### Bezugszeichenliste

- 1: Leuchtenbaugruppe
- 10_1... 10_5: Ebener, spritzgegossener Schaltungsträger
- 20: Metallisierte Leiterbahn
- 21: Metallisierte Fläche
- 22a,: b Anschluss
- 25a, b: Kontaktstift
- 26a, b: Kontaktstift
- 30: LED
- 40: Stanzgitter
- 45: Abschirmung
- 50: Transluzente Abdeckung
- 60_1... 60_5: Antennenstruktur
- 61: Leiterbahn
- 62a,: b Antennenanschluss
- 70: Elektronikabdeckung
- 100: Oberseite
- 101: Unterseite
- 105a, b: Längsverlaufende Seitenwandung
- 106a, b: Querverlaufende Seitenwandung
- 108: Steckergehäuse
- 110: Halbkugel
- 111: Halbkugel

## Patentansprüche

1. Leuchtenbaugruppe (1), umfassend
- einen im Wesentlichen ebenen, spritzgegossenen bzw. gepressten Schaltungsträger (10_1,..., 10_5) mit
- einem zumindest abschnittsweise an den Schaltungsträger gespritzten oder am Schaltungsträger umspritzten bzw. umpressten Steckverbinder,
- einer auf den Schaltungsträger (10_1,..., 10_5) aufgebrachten Metallisierung zur Bereitstellung von Leiterbahnen (20) zur Kontaktierung von auf dem Schaltungsträger kontaktierten elektronischen Bauelementen;
- einer Mehrzahl von auf der Vorderseite des Schaltungsträgers (10_1,..., 10_5) kontaktierten und angeordneten LEDs (30);
- einer am Schaltungsträger (10_1,..., 10_5) angeordneten Sensoreinrichtung zur Erfassung zumindest einer aus der Gruppe der physikalischen Größen Temperatur, Feuchtigkeit, Luftdruck, Schallfeldgrößen, Lichtgrößen und elektromagnetische Feldgrößen ausgewählten Größe;
- zumindest einer mit dem Schaltungsträger (10_1,..., 10_5) einstückig hergestellten Befestigungseinrichtung zur lösbaren Befestigung der Leuchtenbaugruppe (1) an einem Leuchtensystem und
- einem mit dem Schaltungsträger (10_1,..., 10_5) verbundenen und die LEDs abdeckenden lichtlenkenden optischen System.

2. Leuchtenbaugruppe (1) nach Anspruch 1, **gekennzeichnet durch** eine auf dem Schaltungsträger (10_1,..., 10_5) aufgebrachte Metallisierung und/oder zumindest ein umspritztes bzw. umpresstes metallisches Leiterelement zur Bereitstellung von Leiterabschnitten einer als elektronmagnetisch wirksame Antennenstruktur (60_1, ..., 60_5) ausgebildete Sensoreinrichtung.

3. Leuchtenbaugruppe (1) nach Anspruch 1 oder 2,
**dadurch gekennzeichnet, dass** Leiterbahnabschnitte, insbesondere zu einer Antennenstruktur gehörige Leiterbahnabschnitte (61) vollständig im Schaltungsträger (10_1,..., 10_5) umspritzt bzw. umpresst sind.

4. Leuchtenbaugruppe (1) nach Anspruch 1, 2 oder 3,
**dadurch gekennzeichnet, dass** umspritzte bzw. umpresste Leiterbahnabschnitte Stanzteile (40) umfassen.

5. Leuchtenbaugruppe (1) nach Anspruch 1 oder 4,
**dadurch gekennzeichnet, dass** zumindest eine Sensoreinrichtung wie ein Thermosensor oder ein Lichtsensor vorgesehen ist, der zumindest abschnittsweise im Schaltungsträger umspritzt bzw. umpresst ist.

6. Leuchtenbaugruppe (1) nach einem der Ansprüche 1 bis 5, **dadurch gekennzeichnet, dass** umspritzte bzw. umpresste Leiterbahnabschnitte abgeschirmt sind.

7. Leuchtenbaugruppe (1) nach einem der Ansprüche 1 bis 6, **dadurch gekennzeichnet, dass** der ebene, spritzgegossenen bzw. gepresste Schaltungsträger (10_1,..., 10_5) zumindest eine aus seiner Hauptebene herausragende geometrische Strukturierung aufweist.

8. Leuchtenbaugruppe (1) nach Anspruch 7, **dadurch gekennzeichnet, dass** die zumindest eine aus der Hauptebene des Schaltungsträgers (10_1,..., 10_5) herausragende geometrische Strukturierung eine Befestigungseinrichtung zur lösbaren Befestigung der Leuchtenbaugruppe an dem Leuchtensystem umfasst.

9. Leuchtenbaugruppe (1) nach Anspruch 7, **dadurch gekennzeichnet, dass** die zumindest eine aus der Hauptebene des Schaltungsträgers (10_1,..., 10_5) herausragende geometrische Strukturierung eine Befestigungseinrichtung zur Befestigung des die LEDs abdeckenden lichtlenkenden optischen Systems mit dem Schaltungsträger (10_1,..., 10_5) aufweist.

10. Leuchtenbaugruppe (1) nach Anspruch 7, **dadurch gekennzeichnet, dass** die zumindest eine aus der Hauptebene des Schaltungsträgers (10_1,..., 10_5) herausragende geometrische Strukturierung zumindest abschnittsweise die Metallisierung zur Bereitstellung von Leiterbahnen für die elektronmagnetisch wirksame Antennenstruktur (60_1, 60_4, 60_5) trägt.

11. Leuchtenbaugruppe (1) nach Anspruch 7, **dadurch gekennzeichnet, dass** die zumindest eine aus der Hauptebene des Schaltungsträgers (10_1,..., 10_5) herausragende geometrische Strukturierung eine schalenartige Struktur umfasst, die sich von dem im Wesentlichen ebenen Teil des Schaltungsträgers weg erstreckt, wobei die Innenmantelfläche der schalenartigen Struktur metallisiert sein kann.

12. Leuchtenbaugruppe (1) nach einem der Ansprüche 1 bis 11, **gekennzeichnet durch** eine Durchkontaktierung des Schaltungsträgers (10_1,..., 10_5) von der Vorderseite auf die Rückseite zum Anschließen an eine rückseitig angeordnete Schaltungs- oder Anschlussanordnung.

13. Leuchtenbaugruppe (1) nach Anspruch 12, **dadurch gekennzeichnet, dass** der Schaltungsträger (10_1,..., 10_5) auf seiner Rückseite metallisiert ist.

14. Leuchtenbaugruppe (1) nach einem der Ansprüche 1 bis 13, **dadurch gekennzeichnet, dass** ein Metallisierungsabschnitt auf zumindest einer Stirnseite des Schaltungsträgers aufgebracht ist.

15. Leuchtenbaugruppe (1) nach einem der Ansprüche 1 bis 14, **dadurch gekennzeichnet, dass** der zumindest abschnittsweise gespritzte bzw. gepresste oder umspritzte bzw. umpresste Steckverbinder zur Kontaktierung der Leuchtenbaugruppe mit einer elektrischen Versorgung und/oder zur Kontaktierung der Sensoreinrichtung mit einer elektronischen Auswerteschaltung, insbesondere zur Auswertung der von einer Antennenstruktur (60_1, ... 60_5) empfangenen elektromagnetischen Wellen ausgebildet ist.

16. Leuchtenbaugruppe (1) nach einem der Ansprüche 1 bis 15, **gekennzeichnet durch** eine an den Schaltungsträger (10_1,..., 10_5) rückseitig angebrachte Abdeckung (70).

17. Leuchtenbaugruppe (1) nach einem der Ansprüche 1 bis 16, **gekennzeichnet durch** die Metallisierung zur Kontaktierung von Bauelementen zumindest abschnittsweise zur Bereitstellung einer elektronmagnetisch wirksamen Antennenstruktur geschaltet ist.
